# EUROPÄISCHE PATENTSCHRIFT

(11) **EP 1 739 839 B1**
(45) Veröffentlichungstag und Bekanntmachung des Hinweises auf die Patenterteilung: **28.12.2011**
(21) Anmeldenummer: 06113922.6
(22) Anmeldetag: 15.05.2006
(51) Int. Cl.: H03K 17/965, B60K 37/06

(54) **Kraftfahrzeugkomponente mit Näherungssensor und Abschirmung**
Motor-vehicle component with proximity sensor and shielding
Composant de véhicule automobile avec capteur de proximité et avec blindage

(30) Priorität: 24.06.2005 DE 102005029503
(43) Veröffentlichungstag der Anmeldung: 03.01.2007
(73) Patentinhaber: Continental Automotive GmbH, 30165 Hannover (DE)
(72) Erfinder: Born, Frank, 61239 Ober-Mörlen (DE); Mankel, Norbert, 35043 Marburg (DE); Reinhardt, Jörg, 35633 Lahnau (DE); Schäfer, Stefan, 35578 Wetzlar (DE); Wüstenbecker, Dirk, 35614 Aßlar (DE)

(56) Entgegenhaltungen:
- EP-A- 1 228 917
- US-A- 4 466 046
- US-A- 5 363 051
- US-A1- 2002 171 439
- US-A1- 2003 169 231
- US-B1- 6 373 265
- "KEYBOARD WITH VOICE OUTPUT", NTIS TECH NOTES, US DEPARTMENT OF COMMERCE, vol. B, no. 6, 1 June 1986 (1986-06-01), page 672, XP000647298, SPRINGFIELD, VA, US

## Beschreibung

Die Erfindung betrifft eine Kraftfahrzeugkomponente mit einer mindestens ein Bedienelement aufweisenden Bedieneinheit und einer weiteren beweglichen Komponente.

Zur Bedienung von Kraftfahrzeugkomponenten, wie zum Beispiel eines Radiogerätes, eines Navigationsgerätes, eines Autotelefons, einer Multimediaanlage und dergleichen, werden häufig Bedien- und Anzeigeeinrichtungen eingesetzt, die im Fahrzeug ergonomisch angeordnet sind. Die Anzeigeeinrichtung sollte dabei so angeordnet werden, dass der Fahrer diese mit einer möglichst geringen Ablenkung vom Straßenverkehr erfassen kann. Die Anzeigeeinheit wird daher vorzugsweise im Bereich des Armaturenbrettes oder im oberen Bereich einer Mittelkonsole angeordnet. Die Bedieneinheit wird vorzugsweise so angeordnet, dass der Fahrer diese mit den Fingern ohne größere Armbewegung erreichen kann. Diese Anordnung der Bedieneinheit hat jedoch den Nachteil, dass die Bedieneinheit optisch nur sehr schlecht erfasst werden kann. Der Fahrer wird daher dem Bedienelement der Bedieneinheit häufig ohne Sichtkontakt der Tasten auswählen. Es ist daher wünschenswert, die Annäherung einer Hand des Fahrers an ein Bedienelement zu erfassen, um so beispielsweise in der Anzeigeeinrichtung einen Hinweis auf die Art des Bedienelementes bzw. die damit zu bedienende Funktion oder auch eine akustische Rückmeldung ausgeben zu können, bevor das Bedienelement betätigt und die damit verknüpfte Aktion ausgeführt wurde. Im Bereich der Mittelkonsole, in der die Bedieneinheit beispielsweise angeordnet ist, können sich zudem bewegliche Komponenten befinden, wie beispielsweise ein CD-Schacht, so dass ferner eine Bewegung dieser weiteren Komponente nicht fälschlicherweise als eine Annäherung der Hand eines Bedieners an das Bedienelement interpretiert werden darf.

Aus der US 6,373,265 B1 ist ein berührungsempfindliches Bedienelement mit einem beweglich gelagerten Betätigungselement, sowie einem elektrisch leitfähigen Sensorelement eines kapazitiven Sensors bekannt. Mit dem kapazitiven Sensor kann jedoch lediglich eine Bewegung des Betätigungselements erfasst werden.

Aus der US 2003/0169231 A1 ist ein Bedienelement mit einem beweglich in einem Trägerelement gelagerten Betätigungselement und einem elektrisch leitfähigen Sensorelement eines kapazitiven Näherungssensors bekannt, bei dem das Betätigungselement auf ein Schaltelement einwirkt.

Aufgabe der Erfindung ist es daher, eine Kraftfahrzeugkomponente mit einem Bedienelement derart weiterzubilden, dass eine Annäherung an das Bedienelement erkannt wird, gleichzeitig jedoch die herkömmliche Funktionalität eines Bedienelementes, insbesondere eines Drucktasters, nicht beeinträchtigt wird und weiterhin Fehlfunktionen durch benachbarte bewegliche Komponenten vermieden werden.

Die Aufgabe wird durch eine Kraftfahrzeugkomponente mit den Merkmalen des Anspruchs 1 gelöst.

In dem Betätigungselement des Bedienelementes ist ein elektrisch leitfähiges Sensorelement (Sensorelektrode) eines kapazitiven Näherungssensors angeordnet, das elektrisch leitend mit einer Leiterplatte verbunden ist. Durch die Anordnung des Sensorelementes in dem Betätigungselement ist das Sensorelement für den Benutzer nicht sichtbar und beeinträchtigt somit in keiner Weise das optische Erscheinungsbild des Bedienelementes. Durch die entsprechende elektrisch leitfähige Verbindung des Sensorelementes mit der Leiterplatte kann ein Sensorsignal des Sensorelementes in einfacher Weise zu signalverarbeitenden Elementen weitergeleitet werden, die insbesondere auf der Leiterplatte selbst angeordnet sind. Durch geeignete Anordnung des Sensorelementes in dem Betätigungselement und geeignete Verbindung mit der Leiterplatte kann erreicht werden, dass die herkömmliche Funktionalität des Bedienelementes, insbesondere eines Drucktasters, nicht beeinträchtigt wird.

Weiterhin ist in dem Innenraum des Betätigungselementes mindestens ein Abschirmelement angeordnet, das ebenfalls elektrisch leitend mit der Leiterplatte verbunden ist. Durch das Abschirmelement wird eine Einschränkung des Erfassungsbereichs des Sensorelementes erreicht. Das Abschirmelement ist ein mit Masse verbundenes elektrisch leitfähiges Element. Durch das Abschirmelement wird somit insbesondere ein möglicher Einfluss einer beweglichen Komponente, wie beispielsweise eines ausfahrbaren Bildschirms oder eines CD- bzw. DVD-Schachts auf das Sensorelement vermieden. Eine Bewegung der beweglichen Komponente wird somit nicht als eine Annäherung eines Bedieners an das Bedienelement interpretiert. Hierzu ist das mindestens eine Abschirmelement zwischen der beweglichen Komponente und dem Sensorelement angeordnet. Besteht der Wunsch, das Sensorelement gegen Bewegung in verschiedenen Raumrichtungen abzuschirmen, so werden mehrere Abschirmelemente eingesetzt oder das eine Abschirmelement wird entsprechend ausgebildet.

Da der zur Verfügung stehende Innenraum des Betätigungselementes beschränkt ist und neben dem Sensorelement und dem Abschirmelement in der Regel auch ein Beleuchtungselement dort angeordnet werden muss, ist besondere Sorgfalt hinsichtlich der Ausgestaltung des Sensorelementes und des Abschirmelementes erforderlich.

Das mindestens eine Abschirmelement kann stiftförmig ausgebildet sein. Bei dieser Ausgestaltung wird nur sehr wenig Bauraum von dem Abschirmelement in Anspruch genommen, wobei sich jedoch gezeigt hat, dass eine solche Ausgestaltung zur Abschirmung des Einflusses unerwünschter Bewegungen bereits ausreichend ist.

Das Sensorelement kann L- oder T-förmig ausgebildet sein. Bei dieser Ausgestaltung wird eine Sensorfläche zur Verfügung gestellt, die parallel zu einer Frontfläche des Betätigungselementes verläuft und daher besonders zur Detektion von Annäherungen von der Frontseite her an das Bedienelement geeignet ist. Die zu Seitenflächen des Betätigungselementes parallelen Bereiche des Sensorelementes können dann durch Abschirmelemente gegen seitlich vom Bedienelement erfolgende Bewegungen, beispielsweise der Bewegung eines CD-Schachtes, abgeschirmt werden.

Das Sensorelement und das Abschirmelement können spiralfederartig ausgebildet sein, wobei das spiralförmige Sensorelement radial innerhalb des spiralförmigen Abschirmelementes angeordnet ist. Bei dieser Ausgestaltung werden durch das spiralförmige Abschirmelement Bewegungen, die radial zu dem Sensorelement erfolgen, abgeschirmt, während Bewegungen von einer Frontseite ungehindert durch das Abschirmelement von dem Sensorelement detektiert werden können. Insbesondere weist das Betätigungselement hierbei Stege auf, durch die die spiralförmige Ausgestaltung des Sensor- bzw. Abschirmelementes gestützt wird.

Das Sensorelement und das Abschirmelement können federnd vorgespannt an gegenüberliegenden Innenseiten des Betätigungselementes anliegen. Mit dieser Ausgestaltung wird sichergestellt, dass eine Berührung zwischen dem Sensorelement und dem Abschirmelement vermieden wird. Ein Kontakt zwischen dem Abschirmelement und dem Sensorelement muss vermieden werden, da ansonsten das mit Masse verbundene Abschirmelement das Sensorelement ebenfalls mit Masse verbindet und dieses somit seine Funktionsfähigkeit verliert.

Das Sensorelement und das Abschirmelement können jeweils als leitfähige Beschichtung eines Teilbereiches des Betätigungselementes ausgebildet sein. Bei dieser Ausgestaltung sind sowohl das Sensorelement als auch das Abschirmelement direkt in das Betätigungselement integriert, so dass zusätzliche Teile nicht erforderlich sind und die Montage vereinfacht wird. Das Betätigungselement besteht hierbei insbesondere aus einem Zweikomponentenkunststoffteil, wobei eine der Kunststoffkomponenten metallisierbar ist. Durch die Metallisierung dieser Komponente wird sowohl das Sensorelement als auch das Abschirmelement realisiert. Wird eine Seitenwand des Betätigungselementes metallisiert, so kann diese als Abschirmelement Bewegungen aus dieser seitlichen Richtung abschirmen. Entsprechend ausgeprägte Bereiche an dem Betätigungselement können für eine Lötverbindung zu einer Leiterplatte benutzt werden.

Das Sensorelement und das Abschirmelement können an einem hohlzylinderförmigen Bauteil befestigt sein, dessen Innenwand insbesondere reflektierend ausgebildet ist. Bei dieser Ausgestaltung ist somit ein separates Bauteil vorgesehen, an dem sowohl das Sensorelement als auch das Abschirmelement befestigt sind. Alternativ können das Abschirmelement und das Sensorelement wiederum als metallische Oberflächenbeschichtung des hohlzylinderförmigen Bauteils ausgebildet sein. Die hohlzylinderförmige Ausgestaltung des Bauteils hat den Vorteil, dass in dessen Inneren weiterhin eine Lichtquelle zur Beleuchtung des Bedienelementes angeordnet werden kann. Wird die Innenwand des hohlzylinderförmigen Bauteils zudem reflektierend ausgebildet, so kann das Licht der Leuchtquelle ohne größere Verluste für die Beleuchtung des Betätigungselementes genutzt werden.

Das Sensorelement und das Abschirmelement können formschlüssig mittels einer nicht leitenden Zwischenschicht miteinander verbunden sein. Insbesondere bilden das Sensorelement und das Abschirmelement hierbei einen Hohlzylinder, in dessen Ausnehmung wiederum ein Beleuchtungselement angeordnet sein kann. Das Sensorelement und das Abschirmelement können miteinander verklebt, verklipst oder umformtechnisch verbunden, zum Beispiel verstemmt, werden. Das Sensor- und Abschirmelement werden dabei beispielsweise durch eine nicht leitende Beschichtung gegeneinander elektrisch isoliert. Das bereits zusammengefügte Element, bestehend aus Sensorelement und Abschirmelement, wird als Einheit direkt auf der Leiterplatte bestückt und verlötet. Für eine gute Positioniergenauigkeit können zur Zentrierung auf der Leiterplatte Referenzpins in dem Sensorelement und/oder dem Abschirmelement vorgesehen sein. Diese können beim Löten direkt mitverlötet werden. Der Vorteil dieser Ausgestaltung liegt darin, dass nur ein minimaler Bauraumbedarf besteht, da mit sehr dünnen Blechen das Sensorelement und das Abschirmelement realisiert werden können. Zusätzliche Kunststoffteile sind nicht erforderlich.

Mit der Leiterplatte kann eine weitere Leiterplatte verbunden sein, die in den Innenraum des Betätigungselementes ragt und auf der das Sensorelement und das Abschirmelement angeordnet sind. Auch bei sehr kleinem Bauraum kann durch diese Lösung durch den geringen Platzbedarf der weiteren Leiterplatte ein entsprechendes Bedienelement realisiert werden. Auf nur einem zusätzlichen Bauteil, nämlich der weiteren Leiterplatte, sind somit sowohl das Sensorelement als auch das Abschirmelement als leitende Flächen realisiert.

Die Erfindung wird nachfolgend anhand von Ausführungsbeispielen der Zeichnung näher erläutert. Es zeigen:
- Figur 1: eine erste Ausgestaltung eines Drucktasters mit einem stiftförmigen Sensorelement sowie verschiedene Ansichten der Zuordnung von Sensorelement und Abschirmelement,
- Figur 2: eine zweite Ausgestaltung eines Drucktasters mit einem T-förmigen Sensorelement sowie verschiedene Ansichten der Zuordnung von Sensorelement und Abschirmelement,
- Figur 3: eine dritte Ausgestaltung eines Drucktasters mit einem L-förmigen Sensorelement sowie verschiedene Ansichten der Zuordnung von Sensorelement und Abschirmelement,
- Figur 4: eine vierte Ausgestaltung eines Drucktasters mit spiralförmigem Abschirm- und Sensorelement,
- Figur 5: eine fünfte Ausgestaltung eines Drucktasters mit federnd vorgespanntem Sensor- und Abschirmelement,
- Figur 6: eine sechste Ausgestaltung eines Drucktasters mit metallischer Beschichtung zur Erzeugung des Sensor-und Abschirmelementes,
- Figur 7: eine siebente Ausgestaltung eines Drucktasters mit einem hohlzylinderförmigen Bauteil,
- Figur 8: eine achte Ausgestaltung eines Drucktasters mit formschlüssiger Verbindung zwischen Abschirmelement und Sensorelement,
- Figur 9: eine neunte Ausgestaltung eines Drucktasters, bei dem das Sensorelement und das Abschirmelement auf einer Leiterplatte angeordnet sind,
- Figur 10: eine Kraftfahrzeugkomponente.

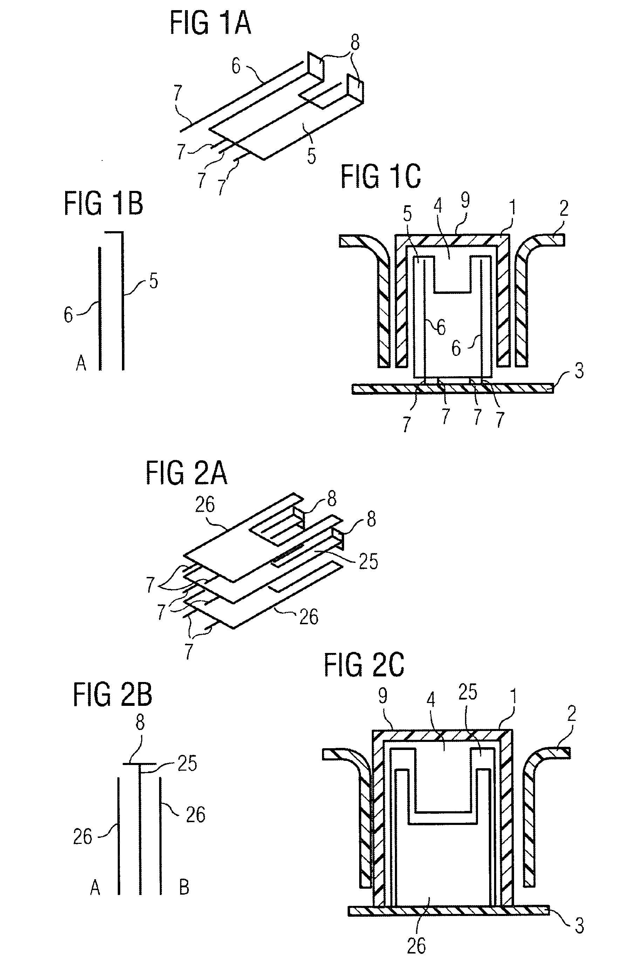

Figur 1c zeigt schematisch einen Drucktaster mit einem linear beweglichen Betätigungselement 1, das in der Blende 2 in herkömmlicher Weise linear beweglich gelagert ist. Bei Druck auf das Betätigungselement 1 wird dieses zur Leiterplatte 3 hin bewegt. Die Rückstellung des Betätigungselementes 1 in die Ruheposition erfolgt beispielsweise durch ein nicht dargestelltes Federelement. Das Betätigungselement 1 weist einen Innenraum 4 auf. In dem Innenraum 4 sind ein Sensorelement 5 sowie zwei stiftartig ausgebildete Abschirmelemente 6 angeordnet. Sowohl das Sensorelement 5 als auch die stiftartigen Abschirmelemente 6 sind durch Anschlusspins 7 leitend mit der Leiterplatte 3 verbunden, die insbesondere weitere Komponenten zur Auswertung des Signals des Sensorelementes 5 enthält.

In Figur 2a ist eine perspektivische Ansicht und in Figur 2b eine Seitenansicht von Sensorelement 5 und stiftartigen Abschirmelementen 6 dargestellt, woraus deren Zuordnung näher ersichtlich ist. Das Sensorelement 5 ist L-förmig ausgebildet, wobei die Sensorflächen 8 einer Frontseite 9 des Betätigungselementes 1 zugeordnet sind und Bewegungen vor der Frontseite 9 detektiert werden. Durch die stiftartigen Abschirmelemente 6 wird dagegen der Einfluss von Bewegungen im Raum A (Figur 1b) auf das Sensorelement 5 unterdrückt. Durch die stiftartige Ausgestaltung der Abschirmelemente 6 benötigen diese nur sehr wenig Bauraum.

Figur 2 zeigt schematisch eine zweite Ausgestaltung einer Drucktaste mit einem Betätigungselement 1, in dessen Innenraum 4 ein Sensorelement 25 und zwei Abschirmelemente 26 angeordnet sind, die jeweils mit der Leiterplatte 3 elektrisch verbunden sind. Der prinzipielle Aufbau der Drucktaste entspricht dem Aufbau gemäß Figur 1, wobei jedoch die Ausbildung der Sensorelemente und der Abschirmelemente unterschiedlich ist.

Figur 2a zeigt eine perspektivische Darstellung der Zuordnung der Abschirmelemente 26 zu dem Sensorelement 25, während Figur 2b eine seitliche Ansicht zeigt. Das Sensorelement 25 ist T-förmig ausgebildet und weist zwei Sensorflächen 8 auf, die der Frontseite 9 des Betätigungselementes 1 zugeordnet sind. Die Abschirmelemente 26 sind flächig ausgebildet und zu beiden Seiten des Sensorelementes 25 angeordnet. Durch diese Anordnung werden sowohl Bewegungen im Raum A als auch im Raum B abgeschirmt und haben somit keinen Einfluss auf das Sensorelement 25. Bei dieser Ausgestaltung werden somit Bewegungen auf zwei Seiten der Drucktaste abgeschirmt.

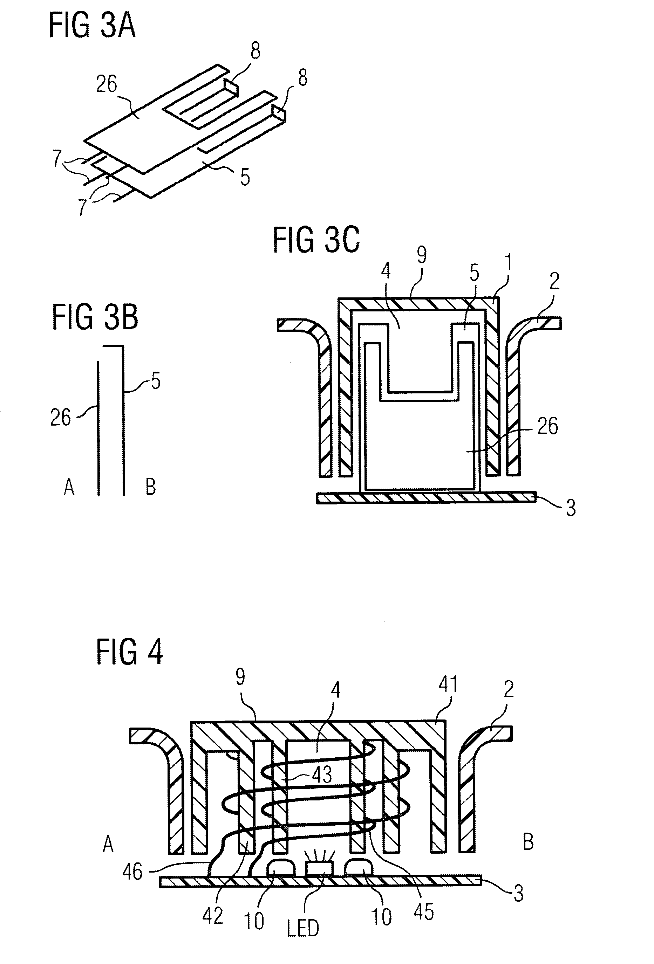

Figur 3 zeigt eine weitere Ausgestaltung einer Drucktaste, wobei im Unterschied zu der Ausgestaltung gemäß Figur 2 hier nur ein Abschirmelement 26 eingesetzt wird und wie bei der Ausgestaltung gemäß Figur 1 ein L-förmiges Sensorelement 5 zum Einsatz kommt. Bei dieser Ausgestaltung wird somit der Einfluss von Bewegungen im Raum A eliminiert, während Bewegungen im Raum B detektiert werden.

Figur 4 zeigt schematisch eine weitere Ausgestaltung eines Drucktasters. Das Betätigungselement 41 weist hier nun Stege 42 und 43 auf. Das Sensorelement 45 und das Abschirmelement 46 sind spiralförmig ausgebildet und werden durch die Stege 42, 43 geführt. Der Radius des spiralförmigen Abschirmelementes 46 ist größer als der Radius des spiralförmigen Sensorelementes 45, so dass der Einfluss von seitlich in den Räumen A und B auftretenden Bewegungen auf das Sensorelement 45 eliminiert wird. Das Sensorelement 45 erstreckt sich jedoch näher zur Frontseite 9 hin als das Abschirmelement 46, so dass Bewegungen vor der Frontseite 9 durch das Sensorelement 45 detektiert werden.

Auf der Leiterplatte 3 ist weiterhin eine Leuchtdiode LED angeordnet. Weiterhin sind auf der Leiterplatte 3 zwei Schaltelemente 10 angeordnet, auf die das Betätigungselement 41 einwirkt. Eine derartige Leuchtdiode LED und derartige Schaltelemente 10 können auch bei allen vorausgehend und nachfolgend beschriebenen Ausführungsformen vorhanden sein.

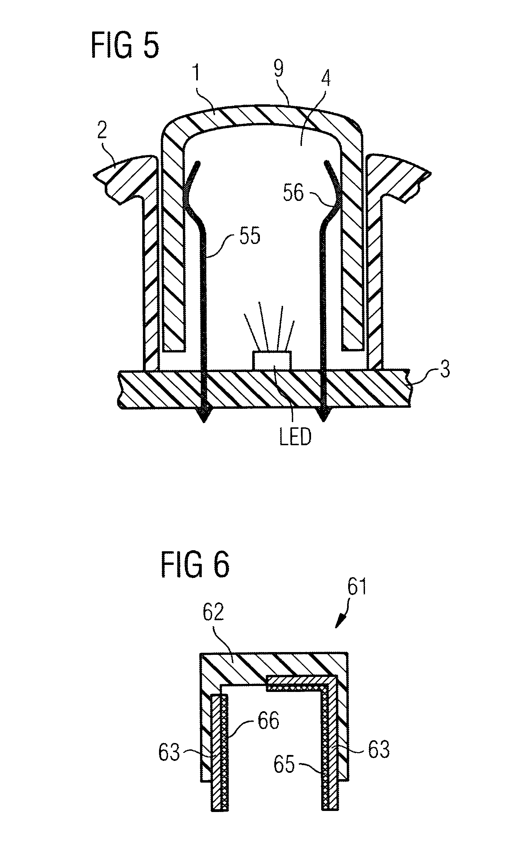

Figur 5 zeigt schematisch eine weitere Ausgestaltung eines Drucktasters, wobei nunmehr das Sensorelement 55 und das Abschirmelement 56 federnd vorgespannt an gegenüberliegenden Seiten des Betätigungselementes 1 anliegen. Durch die spezielle Ausgestaltung des Sensorelementes 55 und des Betätigungselementes 56 zur Erzeugung einer federnden Vorspannung werden diese sicher innerhalb des Betätigungselementes positioniert, so dass ein versehentlicher Kontakt zwischen dem Sensorelement 55 und dem Abschirmelement 56 auch bei Verwendung des Drucktasters in Kraftfahrzeugen und den dort ständig auftretenden Erschütterungen sicher vermieden wird. Weiterhin verbleibt ausreichend Platz für eine Leuchtdiode LED.

Figur 6 zeigt eine weitere Ausgestaltung eines Betätigungselementes 61, das in einem erfindungsgemäßen Bedienelement verwendet werden kann. Das Betätigungselement 61 ist als Zweikomponentenspritzgießteil hergestellt, und zwar mit einer ersten Komponente 62 aus einem ersten, nicht metallisierbaren Kunststoffmaterial und einer zweiten Komponente 63 aus einem metallisierbaren Kunststoffmaterial. Auf der zweiten Komponente 63 wird das Sensorelement 65 bzw. das Abschirmelement 66 als metallische Oberflächenbeschichtung realisiert. Der Vorteil dieser Ausgestaltung liegt darin, dass sowohl das Sensorelement 65 als auch das Abschirmelement 66 direkt in das Betätigungselement 61 integriert sind. Die Kontaktierung des Sensorelementes 65 bzw. Abschirmelementes 66 mit einer Leiterplatte kann beispielsweise über Schleifer erfolgen. Alternativ kann auch eine Lötverbindung von entsprechend ausgeprägten Bereichen des Kunststoffspritzgussteils, die das Sensorelement 65 bzw. das Abschirmelement 66 enthalten, mit der Leiterplatte erfolgen.

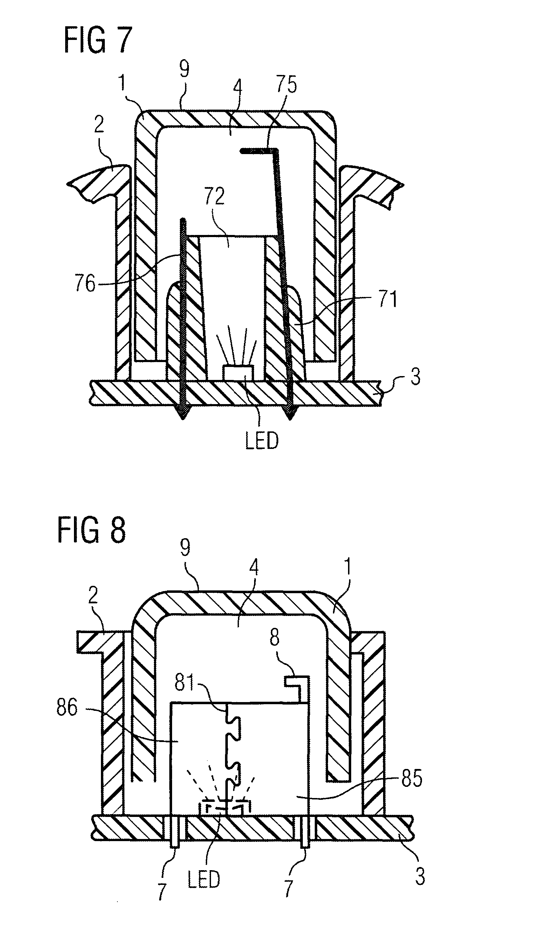

Figur 7 zeigt ein weiteres Ausführungsbeispiel, bei dem im Innenraum 4 des Betätigungselementes 1 ein hohlzylinderförmiges Bauteil 71 angeordnet ist. An dem Bauteil 71 sind sowohl das Abschirmelement 76 als auch das Sensorelement 75, die beide als Metallteile ausgebildet sind, befestigt. Das Sensorelement 75 und das Abschirmelement 76 sind mit der Leiterplatte 3 verlötet, wodurch das hohlzylinderförmige Bauteil 71 auf der Leiterplatte 3 gehalten wird. Auf der Leiterplatte 3 ist ferner eine Leuchtdiode LED angeordnet, die von dem hohlzylinderförmigen Bauteil 71 radial umgeben ist. Die Innenwand 72 des hohlzylinderförmigen Bauteils 71 ist reflektierend ausgebildet, so dass das von der Leuchtdiode LED erzeugte Licht mit nur geringen Verlusten zur Frontseite 9 des Betätigungselementes 1 gelangt. Durch die Integration des Sensorelementes 75 und des Abschirmelementes 76 in das hohlzylinderförmige Bauteil 71 werden das Sensorelement 75 und das Abschirmelement 76 somit in einer einzigen Komponente realisiert, wodurch die Montage wesentlich vereinfacht wird. Weiterhin sind das Abschirmelement 76 und das Sensorelement 75 bei dieser Anordnung sicher fixiert, wodurch auch bei Verwendung in einem Kraftfahrzeug ein Kontakt zwischen dem Sensorelement 75 und dem Abschirmelement 76 sicher verhindert wird.

Figur 8 zeigt schematisch ein weiteres Ausführungsbeispiel eines Drucktasters. Das Sensorelement 85 und das Abschirmelement 86 sind hierbei formschlüssig miteinander verbunden und bilden ein hohlzylinderförmiges Bauteil, das auf der Leiterplatte 3 mittels Anschlusspins 7 verlötet ist. Auf der Leiterplatte 3 ist wiederum eine Leuchtdiode LED angeordnet, die von dem durch das Sensorelement 85 und das Abschirmelement 86 gebildeten Bauteil radial umschlossen wird. Das Sensorelement 85 und das Abschirmelement 86 sind durch dünne Bleche realisiert und benötigen daher nur einen minimalen Bauraum. Gleichzeitig dienen das Sensorelement 85 und das Abschirmelement 86 der Lichtabschottung und verhindern den seitlichen Austritt des von der Leuchtdiode LED erzeugten Lichtes. Die Verbindungsstelle 81 zwischen dem Sensorelement 85 und dem Abschirmelement 86 isoliert diese beiden Elemente elektrisch gegeneinander. Die Verbindung kann insbesondere über Kleben, einen umformtechnischen Prozess, wie beispielsweise Verstemmen, oder durch Verklipsen erfolgen.

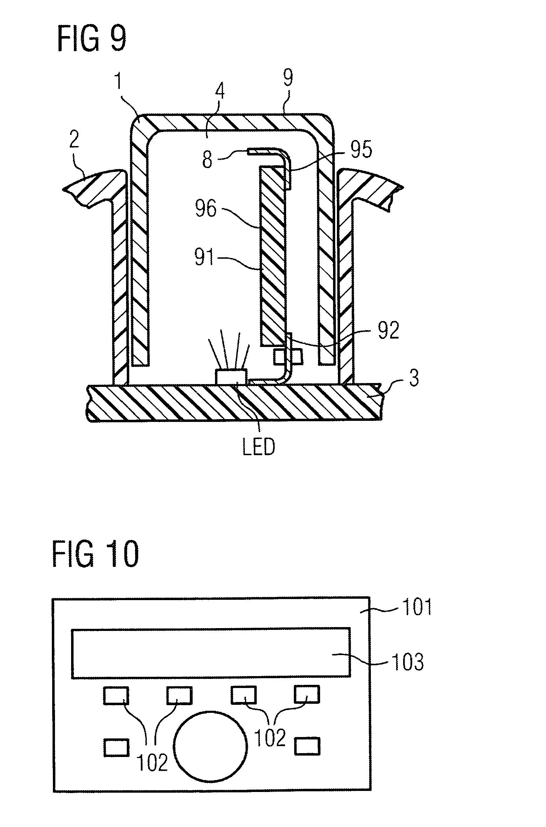

Figur 9 zeigt ein weiteres Ausführungsbeispiel eines Drucktasters. Im Innenraum 4 des Betätigungselementes 1 ist nunmehr eine weitere Leiterplatte 91 angeordnet, die sowohl das Sensor- als auch das Abschirmelement enthält. Sowohl das Sensor- als auch das Abschirmelement können dabei als leitfähige Beschichtung der Leiterplatte ausgebildet sein. Im gezeigten Ausführungsbeispiel ist das Abschirmelement 96 als eine derartige Beschichtung auf einer Seite der Leiterplatte 91 ausgeführt, während das Sensorelement 95 als Metallelement mit der Sensorfläche 8 ausgebildet ist. Das Sensorelement 95 ist mit der Leiterplatte 3 über eine nicht dargestellte Leiterbahn und das Anschlusselement 92 verbunden.

Figur 10 zeigt eine Kraftfahrzeugkomponente 101 mit mehreren Bedienelementen 102, die gemäß einer der zuvor beschriebenen Ausführungsformen ausgebildet sein können. Oberhalb der Bedienelemente 102 ist eine weitere bewegliche Komponente 103 angeordnet, bei der es sich beispielsweise um einen CD-Schacht oder einen ausfahrbaren Monitor handeln kann. Um nun eine Bewegung der beweglichen Komponente 103 nicht irrtümlich als eine Annäherung eines Bedieners an eines der Bedienelemente 102 zu interpretieren, weisen die Bedienelement 102 einen erfindungsgemäßen Aufbau mit einem Abschirmelement auf, wobei das Abschirmelement zwischen dem Sensorelement und der beweglichen Komponente 103 angeordnet ist. Im gezeigten Beispiel der Figur 10 werden somit Bewegungen, die oberhalb eines Bedienelementes 102 erfolgen, durch das in das Bedienelement 102 eingebaute Sensorelement nicht detektiert.

## Patentansprüche

1. Kraftfahrzeugkomponente mit einer mindestens ein Bedienelement (102) aufweisenden Bedieneinheit und einer weiteren beweglichen Komponente (103), wobei das das Bedienelement (102) ein beweglich in einem Trägerelement gelagertes Betätigungselement (1; 41; 61) aufweist, das insbesondere auf ein Schaltelement (10) einwirkt und wobei in einem Innenraum (4) des Betätigungselements (1; 41; 61) ein elektrisch leitfähiges Sensorelement (5; 25; 45; 55; 65; 75; 85; 95) eines kapazitiven Näherungssensors sowie mindestens ein Abschirmelement (6; 26; 46; 56; 66; 76; 86; 96) angeordnet sind, wobei das Sensorelement (5; 25; 45; 55; 65; 75; 85; 95) und das Abschirmelement (6; 26; 46; 56; 66; 76; 86; 96) elektrisch leitend mit einer Leiterplatte (3) verbunden sind, wobei das mindestens eine Abschirmelement (6; 26; 46; 56; 66; 76; 86; 96) zwischen der beweglichen Komponente (103) und dem Sensorelement (5; 25; 45; 55; 65; 75; 85; 95) angeordnet ist.

2. Kraftfahrzeugkomponente nach Anspruch 1, **dadurch gekennzeichnet , dass** es sich bei dem Bedienelement um einen Drucktaster handelt, wobei das Betätigungselement **(**(1; 41; 61) linear beweglich gelagert ist.

3. Kraftfahrzeugkomponente nach Anspruch 1 oder 2, da - durch gekennzeichnet, dass das Abschirmelement (6) stiftförmig ausgebildet ist.

4. Kraftfahrzeugkomponente nach einem der vorhergehenden Ansprüche, **dadurch gekennzeichnet, dass** das Sensorelement (5; 25) L- oder T-förmig ausgebildet ist.

5. Kraftfahrzeugkomponente nach Anspruch 1 oder 2, **dadurch gekennzeichnet, dass** sowohl das Sensorelement (45) als auch das Abschirmelement (46) spiralförmig ausgebildet sind, wobei das spiralförmige Sensorelement (45) radial innerhalb des spiralförmigen Abschirmelements (46) angeordnet ist.

6. Kraftfahrzeugkomponente nach Anspruch 1 oder 2, **dadurch gekennzeichnet, dass** das Sensorelement (55) und das Abschirmelement (56) federnd vorgespannt an gegenüberliegenden Innenseiten des Betätigungselements (1) anliegen.

7. Kraftfahrzeugkomponente nach Anspruch 1 oder 2, **dadurch gekennzeichnet, dass** das Sensorelement (65) und das Abschirmelement (66) jeweils als leitfähige Beschichtung eines Teilbereichs des Betätigungselements ausgebildet sind.

8. Kraftfahrzeugkomponente nach Anspruch 1 oder 2, **dadurch gekennzeichnet, dass** das Sensorelement (75) und das Abschirmelement (76) an einem hohlzylinderförmigen Bauteil (71), dessen Innenwand (72) insbesondere reflektierend ausgebildet ist, befestigt sind oder auf das hohlzylinderförmige Bauteil (71) als Beschichtung aufgebracht sind.

9. Kraftfahrzeugkomponente nach Anspruch 1 oder 2, **dadurch gekennzeichnet, dass** das Sensorelement (85) und das Abschirmelement (86) formschlüssig mittels einer nicht leitenden Zwischenschicht miteinander verbunden sind.

10. Kraftfahrzeugkomponente nach Anspruch 1 oder 2, **dadurch gekennzeichnet, dass** mit der Leiterplatte (3) eine weitere Leiterplatte (91) verbunden ist, die in den Innenraum (4) des Betätigungselements (1) ragt und auf der das Sensorelement (95) und das Abschirmelement (96) angeordnet sind.

## Claims

1. Motor vehicle component comprising an operating unit, having at least one operating element (102), and a further movable component (103), having an actuating element (1; 41; 61) that is movably supported in a carrier element and acts, in particular, on a switch element (10), and an electrically conductive sensor element (5; 25; 45; 55; 65; 75; 85; 95) of a capacitive proximity sensor and at least one shielding element (6; 26; 46; 56; 66; 76; 86; 96) being arranged in an interior space (4) of the actuating element (1; 41; 61), the sensor element (5; 25; 45; 55; 65; 75; 85; 95) and the shielding element (6; 26; 46; 56; 66; 76; 86; 96) being connected to a printed circuit board (3) in an electrically conducting fashion, the at least one shielding element (6; 26; 46; 56; 66; 76; 86; 96) being arranged between the movable component (103) and the sensor element (5; 25; 45; 55; 65; 75; 85; 95).

2. Motor vehicle component according to Claim 1, **characterized in that** the operating element is a pushbutton, the actuating element (1; 41; 61) being supported in a linearly movable fashion.

3. Motor vehicle component according to Claim 1 or 2, **characterized in that** the shielding element (6) is designed in the shape of a pin.

4. Motor vehicle component according to one of the preceding claims, **characterized in that** the sensor element (5; 25) is designed in an L-shaped or T-shaped fashion.

5. Motor vehicle component according to Claim 1 or 2, **characterized in that** both the sensor element (45) and the shielding element (46) are designed in the shape of a spiral, the spiral-shaped sensor element (45) being arranged radially inside the spiral-shaped shielding element (46).

6. Motor vehicle component according to Claim 1 or 2, **characterized in that** the sensor element (55) and the shielding element (56) bear against opposite internal sides of the actuating element (1) in a resiliently biased fashion.

7. Motor vehicle component according to Claim 1 or 2, **characterized in that** the sensor element (65) and the shielding element (66) are respectively designed as a conductive coating of a subregion of the actuating element.

8. Motor vehicle component according to Claim 1 or 2, **characterized in that** the sensor element (75) and the shielding element (76) are fastened on a hollow cylindrical member (71) whose inside wall (72) is, in particular, of reflecting design, or are applied as a coating to the hollow cylindrical member (71) .

9. Motor vehicle component according to Claim 1 or 2, **characterized in that** the sensor element (85) and the shielding element (86) are interconnected in a self-closed fashion by means of a nonconducting intermediate layer.

10. Motor vehicle component according to Claim 1 or 2, **characterized in that** connected to the printed circuit board (3) is a further printed circuit board (91) which projects into the interior space (4) of the actuating element (1) and on which the sensor element (95) and the shielding element (96) are arranged.

## Revendications

1. Composant de véhicule automobile ayant une unité de commande comportant au moins un élément (102) de commande et ayant un autre composant (103) mobile, dans lequel l'élément (102) de commande a un élément (1; 41; 61) d'actionnement monté mobile dans un élément de support et agissant notamment sur un élément (10) de commutation et dans lequel, à l'intérieur (4) de l'élément (1; 41; 61) d'actionnement, sont placés un élément (5; 25; 45; 55; 65; 75; 85; 95) formant capteur conducteur de l'électricité d'un capteur de proximité capacitif, ainsi qu'au moins un élément (6; 26; 46; 56; 66;76; 86; 96) de blindage, l'élément (5; 25; 45; 55; 65; 75; 85; 95) formant capteur et l'élément (6; 26; 46; 56; 66; 76; 86; 96) de blindage étant reliés d'une manière conductrice de l'électricité à une plaquette à circuit imprimé (3), dans lequel le au moins un élément (6; 26; 46; 56; 66; 76; 86; 96) de blindage est disposé entre le composant (103) mobile et l'élément (5; 25; 45; 55; 65; 75; 85; 95) formant capteur.

2. Composant de véhicule automobile suivant la revendication 1, **caractérisé en ce que** l'élément de commande est un bouton poussoir, l'élément (1; 41; 61) d'actionnement étant monté mobile linéairement.

3. Composant de véhicule automobile suivant la revendication 1 ou 2, **caractérisé en ce que** l'élément (6) de blindage est en forme de broche.

4. Composant de véhicule automobile suivant l'une des revendications, **caractérisé en ce que** l'élément (5; 25) formant capteur est en forme de L ou en forme de T.

5. Composant de véhicule automobile suivant la revendication 1 ou 2, **caractérisé en ce qu'**à la fois l'élément (45) formant capteur et l'élément (46) de blindage sont en forme de spirale, l'élément (45) formant capteur en forme de spirale étant disposé à l'intérieur de l'élément (46) de blindage en forme de spirale.

6. Composant de véhicule automobile suivant la revendication 1 ou 2, **caractérisé en ce que** l'élément (55) formant capteur et l'élément (56) de blindage s'appliquent en étant précontraints élastiquement à des côtés intérieurs opposés de l'élément (1) d'actionnement.

7. Composant de véhicule automobile suivant la revendication 1 ou 2, **caractérisé en ce que** l'élément (65) formant capteur et l'élément (66) de blindage sont constitués respectivement sous la forme de revêtement conducteur d'une zone partielle de l'élément d'actionnement.

8. Composant de véhicule automobile suivant la revendication 1 ou 2, **caractérisé en ce que** l'élément (75) formant capteur et l'élément (76) de blindage sont fixés sur un élément constitutif (71) en forme de cylindre creux et dont la paroi (72) intérieure est notamment réfléchissante ou sont appliqués en revêtement sur l'élément (71) constitutif en forme de cylindre creux.

9. Composant de véhicule automobile suivant la revendication 1 ou 2, **caractérisé en ce que** l'élément (85) formant capteur et l'élément (86) de blindage sont assemblés entre eux à complémentarité de forme au moyen d'une couche intermédiaire non conductrice.

10. Composant de véhicule automobile suivant la revendication 1 ou 2, **caractérisé en ce qu'** à la plaquette à circuit imprimé (3) est reliée une autre plaquette à circuit imprimé (91), qui pénètre à l'intérieur (4) de l'élément (1) d'actionnement et sur laquelle sont montés l'élément (95) formant capteur et l'élément (96) de blindage.
